# FASCICULE DE BREVET EUROPEEN

(11) **EP 3 678 169 B1**
(45) Date de publication et mention de la délivrance du brevet: **16.09.2026**
(21) Numéro de dépôt: 19220270.3
(22) Date de dépôt: 31.12.2019
(51) Int. Cl.: H10P 54/50

(54) **PROCÉDÉ DE TRANSFERT DE COUCHE AVEC RÉDUCTION LOCALISÉE D'UNE CAPACITÉ À INITIER UNE FRACTURE**
TRANSFERVERFAHREN EINER SCHICHT MIT LOKALISIERTER REDUZIERUNG DER FÄHIGKEIT, EINEN BRUCH AUSZULÖSEN
METHOD FOR TRANSFERRING A LAYER WITH LOCALISED REDUCTION OF CAPACITY TO INITIATE A FRACTURE

(30) Priorité: 07.01.2019 FR 1900127
(43) Date de publication de la demande: 08.07.2020
(73) Titulaire: Commissariat à l'Energie Atomique et aux Energies Alternatives, 75015 Paris (FR)
(72) Inventeur: REBOH, Shay, 38054 GRENOBLE Cedex 09 (FR); MAZEN, Frédéric, 38054 GRENOBLE CEDEX 09 (FR); ACOSTA ALBA, Pablo, 38054 GRENOBLE CEDEX 09 (FR)
(74) Mandataire: Santarelli

(56) Documents cités:
- WO-A1-2018/149906
- US-A1- 2016 233 125

## Description

### DOMAINE TECHNIQUE

Le domaine de l'invention est celui des procédés de transfert d'une couche d'un substrat donneur vers un substrat receveur qui mettent en œuvre une fracturation le long d'un plan de fragilisation formé dans le substrat donneur. L'invention concerne plus particulièrement le contrôle du processus de fracturation.

### TECHNIQUE ANTÉRIEURE

La technologie Smart Cut^{™} est une technique bien connue pour permettre le transfert de couches minces de matériaux par exemple semi-conducteurs. Selon cette technique, des espèces ioniques telles que l'hydrogène ou l'hélium sont implantées dans un substrat donneur afin d'y former un plan de fragilisation. Le substrat donneur est par la suite mis en contact avec un substrat receveur, par exemple par collage direct. Cette technique fait ensuite appel au développement des défauts générés lors de l'implantation pour conduire à la fracturation. Ce développement implique un apport énergétique, généralement réalisé au moyen d'un traitement thermique, afin de permettre la formation d'une couche confinée de cavités et de micro-fissures au sein de laquelle va s'initier et se propager une onde de fracture. Cette onde va progressivement s'étendre tout au long du plan de fragilisation conduisant à la séparation la couche mince superficielle délimitée par ce plan de fragilisation et le reste du substrat.

Le document US2016/0233125 divulgue un procédé de report d'une couche utile.

Le document WO 2018/029419 A1, qui divulgue les caractéristiques du préambule de la revendication 1, expose que l'interaction entre la propagation de l'onde de fracture et des vibrations acoustiques émises lors de l'initiation et/ou de la propagation de l'onde de fracture conduit à la formation de motifs périodiques de variations d'épaisseur et/ou de rugosité de la couche transférée, qui s'étendent sur toute la surface de cette couche. En d'autres termes, l'onde de fracture est déviée verticalement de son plan de progression selon l'état des contraintes instantanées du matériau qu'elle traverse, cet état de contrainte étant influencé par l'onde acoustique.

L'absence de contrôle précis de la localisation de l'initiation de l'onde de fracture engendre une variabilité entre couches minces transférées, notamment en termes de rugosité et/ou d'épaisseur, variabilité qui nécessite de mettre en œuvre des contrôles post-fracture plus poussés et/ou des traitements post-fracture spécifiques. Afin de limiter cette variabilité, on cherche donc à initier l'onde de fracture de manière standardisée. Dans le document WO 2018/029419 A1 cité préalablement, on vient pour cela créer des zones, localisées sur le wafer, où la fracture s'initie préférentiellement. Une telle création peut notamment consister à :
- réaliser un surdosage localisé dans une zone cible des espèces implantés lors de la formation du plan de fragilisation dans le substrat donneur ; ou encore à
- réaliser un surplus de budget thermique localisé dans une zone cible des espèces implantés lors de la formation du plan de fragilisation pour faire croitre plus rapidement les défauts dans cette zone du plan de fragilisation.

Le document WO2018149906 A1 décrit un procédé comprenant une première étape d'implantation dans la partie centrale du substrat donneur, suivie d'une seconde implantation, à dose plus faible, à la périphérie du substrat donneur, créant ainsi une réduction localisée de la capacité du plan de fragilisation à initier l'onde de fracture.

### EXPOSÉ DE L'INVENTION

L'invention propose une technique complémentaire ou alternative aux techniques susmentionnées de confinement de la localisation de l'initiation de l'onde de fracture en une zone cible du plan de fragilisation. Elle concerne plus particulièrement un procédé de transfert d'une couche mince d'un substrat donneur vers un substrat receveur, le substrat donneur comportant un plan de fragilisation délimitant la couche mince et une partie massive du substrat donneur, le procédé comprenant les étapes suivantes :
- implantation d'espèces réalisée de manière uniforme sur l'ensemble du substrat donneur pour y former un plan de fragilisation qui délimite la couche mince et une partie massive du substrat donneur,
- mise en contact du substrat donneur et du substrat receveur,
- initiation et propagation d'une onde de fracture le long du plan de fragilisation.

Ce procédé comprend en outre, avant la mise en contact, une étape de réduction localisée d'une capacité du plan de fragilisation à initier l'onde de fracture.

Certains aspects préférés mais non limitatifs de ce procédé sont les suivants :
- lors de l'étape de réduction localisée de la capacité du plan de fragilisation à initier l'onde de fracture, une zone centrale du plan de fragilisation n'est pas soumise à la réduction de la capacité à initier l'onde de fracture ;
- lors de l'étape de réduction localisée de la capacité du plan de fragilisation à initier l'onde de fracture, une couronne périphérique du plan de fragilisation est soumise à la réduction de la capacité à initier l'onde de fracture ;
- lors de l'étape de réduction localisée de la capacité du plan de fragilisation à initier l'onde de fracture, une couronne périphérique du plan de fragilisation, à l'exception d'un secteur de la couronne périphérique, est soumise à la réduction de la capacité à initier l'onde de fracture ;
- l'initiation de l'onde de fracture comprend un apport d'énergie localisé au niveau du secteur de la couronne périphérique non soumis à la réduction de la capacité à initier l'onde de fracture ;
- la couronne périphérique est localisée en bordure du plan de fragilisation ; l'étape de réduction localisée de la capacité du plan de fragilisation à initier l'onde de fracture comprend la réalisation d'un recuit laser localisé du substrat donneur ;
- la réalisation du recuit laser localisé du substrat donneur comprend une irradiation localisée d'une face libre de la couche mince par une ou plusieurs impulsions laser ;
- l'étape de réduction localisée de la capacité du plan de fragilisation à initier l'onde de fracture comprend la formation d'une zone amorphe localisée dans la couche mince ;
- la zone amorphe est localisée à moins de 100 nm, de préférence à moins de 75 nm, et encore plus de préférence à moins de 50 nm du plan de fragilisation.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1 représente la lumière diffuse émise par la surface d'un substrat de silicium en fonction de la fluence énergétique d'une impulsion laser venant l'irradier.
La figure 2 représente des observations microscopiques de la surface de régions d'un substrat soumises à différents niveaux énergétiques d'irradiation laser.
La figure 3 représente des observations microscopiques de la surface de régions d'un substrat soumises à différents nombres d'impulsions laser.
La figure 4 illustre une première réalisation possible de la réduction localisée de la capacité du plan de fragilisation à initier la fracture.
La figure 5 illustre une deuxième réalisation possible de la réduction localisée de la capacité du plan de fragilisation à initier la fracture.
La figure 6 illustre une troisième réalisation possible de la réduction localisée de la capacité du plan de fragilisation à initier la fracture.
La figure 7 représente une épaisseur de silicium amorphisée par une implantation de silicium, en fonction de différentes conditions d'implantation.

### DESCRIPTION DÉTAILLÉE

L'invention porte sur un procédé de transfert d'une couche mince d'un substrat donneur vers un substrat receveur. Le substrat donneur peut être un substrat de silicium, ou en tout autre matériau semi-conducteur ou non. À titre d'exemples, il peut s'agir de silicium-germanium, de germanium ou d'un matériau III-V.

Le procédé comprend une étape de formation dans le substrat donneur d'un plan de fragilisation délimitant la couche mince et une partie massive du substrat donneur. Ce plan de fragilisation est formé par implantation d'espèces, typiquement de l'hydrogène et/ou de l'hélium, réalisée de manière uniforme (notamment en dose) sur l'ensemble du substrat donneur. Ainsi la dose d'espèces implantées est uniforme sur toute l'étendue du plan de fragilisation et le plan de fragilisation présente une capacité à initier une onde de fracture uniforme sur toute son étendue.

Le procédé comprend la mise en contact du substrat donneur et du substrat receveur pour former un ensemble à fracturer. Cette formation peut être réalisée par assemblage direct, par exemple par adhésion moléculaire. Puis, suite à la mise en contact, le procédé comprend l'initiation et la propagation de l'onde de fracture le long du plan de fragilisation, ce qui conduit au détachement de la couche mince du substrat donneur et à son transfert sur le substrat receveur. Cette initiation et propagation de l'onde de fracture comprend un traitement thermique dit de fragilisation appliqué à l'ensemble à fracturer. Ce traitement thermique fragilise le substrat donneur au niveau de son plan de fragilisation 2, et fournit l'énergie suffisante pour que l'onde de fracture, une fois initiée, se propage de manière auto-entretenue.

Dans une première variante de mise en œuvre, le traitement thermique est suffisant à lui seul pour initier l'onde de fracture. Dans une seconde variante de mise en œuvre, le procédé comprend un apport d'énergie additionnelle localisé, après ou pendant le traitement thermique de fragilisation, pour initier l'onde de fracture. Cette énergie peut être d'origine mécanique, thermique ou de toute autre origine. Il peut s'agir par exemple d'un chauffage localisé réalisé par un laser, ou d'un apport d'énergie par ultrasons.

Selon l'invention, l'initiation de l'onde de fracture est spatialement contrôlée en venant réduire, voire inhiber, la capacité d'une ou plusieurs zones cibles du plan de fragilisation à initier l'onde de fracture. Pour ce faire, le procédé comprend, avant la mise en contact des substrats donneur et receveur, l'application au substrat donneur d'un traitement de réduction localisée de la capacité du plan de fragilisation à initier l'onde de fracture. Cette réduction spatialement sélective fait que l'initiation de l'onde de fracture est localisée dans une région du plan de fragilisation différente de la ou des zones cibles qui ont une probabilité d'initiation de l'onde de fracture rendue plus faible par ledit traitement. Et comme cela sera détaillé par la suite, dans un mode de réalisation, la réduction localisée de la capacité à initier l'onde de fracture est réalisée de manière à réduire la probabilité d'initiation de l'onde de fracture par une zone cible sans pour autant que cette zone cible ne fasse obstacle à la propagation de l'onde de fracture.

On décrit dans ce qui suit une méthodologie pour déterminer des conditions opératoires d'un traitement du substrat donneur permettant de réduire voire d'inhiber la capacité d'une zone cible du plan de fragilisation à initier l'onde de fracture.

Lors d'un traitement thermique appliqué à un substrat implanté non assemblé à un raidisseur, les défauts liés à l'implantation évoluent sous forme de cavités qui peuvent être à l'origine d'un cloquage voire d'une exfoliation de la couche implantée. Dans le domaine de l'invention, on considère généralement que des paramètres opératoires conduisant à une tel cloquage/exfoliation d'un substrat non-assemblé vont également permettre de réaliser le transfert d'une couche mince lorsque le substrat est assemblé avec un raidisseur.

Dans un mode de réalisation possible de l'invention, la réduction localisée de la capacité du plan de fragilisation à initier l'onde de fracture peut comprendre la réalisation d'un recuit laser localisé du substrat donneur. Les inventeurs ont effectivement pu vérifier qu'en irradiant localement un substrat implanté avec un faisceau laser, il est possible de réduire voire d'inhiber les phénomènes de cloquage/exfoliation dans les zones irradiées alors que ces phénomènes sont observés de manière usuelle dans les zones non irradiées. L'absence de cloquage/exfoliation dans les zones irradiées fait que ces zones ne peuvent venir initier une onde de fracture.

Des conditions opératoires du tel recuit laser localisé peuvent être déterminées comme décrit ci-après sur la base d'un exemple de réalisation du procédé selon l'invention qui utilise un substrat donneur en silicium présentant un plan de fragilisation formée par implantation d'hydrogène et d'hélium avec des énergies dans la gamme 30-40 keV et une dose totale (H + He) de l'ordre de 2.10¹⁶ ions/cm². Le recuit laser est un recuit laser du type nanoseconde NSLA (« NanoSecond Laser Annealing) exploitant dans un premier temps une seule impulsion d'irradiation de longueur d'onde 380 nm et de durée (largeur à mi-hauteur) 160 ns. Différentes régions du substrat donneur sont irradiées avec une fluence énergétique allant de 0,4 J/cm² à 3,125 J/cm² par pas de 0,025 J/cm² et la qualité de la surface du substrat donneur est évaluée au moyen d'une mesure de bruit de fond diffus (« haze » selon la terminologie anglo-saxonne communément employée) correspondant à l'intensité de la lumière diffusée par la surface de la couche, à l'aide de l'outil d'inspection Surfscan^{®} SP2 de la société KLA-Tencor.

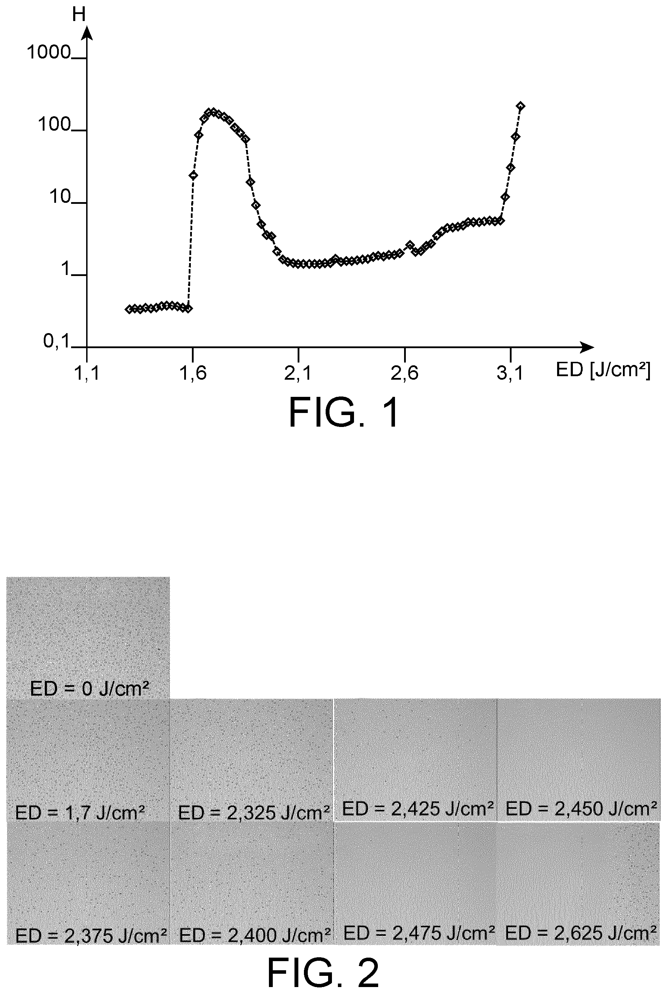

La figure 1 représente ainsi le bruit de fond diffus H émis par une région du substrat donneur (en unité arbitraire) en fonction de la fluence énergétique ED (en J/cm²). On constate un pic d'intensité du bruit H pour des fluences globalement comprises entre 1,6 et 1,9 J/cm². Ce pic est lié à une augmentation de la rugosité de surface du fait de la formation de structures surfaciques dont la présence, constatée en microscopie électronique à balayage SEM (« Scanning Electron Microscopy »), peut être associée à un commencement de fusion de la surface. Puis pour des fluences supérieures à 2 J/cm², on constate toujours par SEM qu'une bonne qualité de surface est de nouveau obtenue, ce qui peut être lié à une recristallisation faisant suite à une fusion totale de la surface au cours de l'irradiation. Pour des fluences supérieures à 3 J/cm², un nouveau pic d'intensité du bruit H est observé et on constate par SEM un phénomène de déformation de surface venant créer des cratères.

Le substrat donneur ainsi irradié est soumis à un traitement thermique à 500°C pendant deux minutes pour vérifier la présence ou l'absence de cloquage au niveau des différentes régions irradiées, et donc la possibilité ou non de venir initier la fracturation. La figure 2 représente des observations microscopiques de la surface de différentes régions du substrat et on constate que plus la fluence ED de l'irradiation est importante plus le phénomène de cloquage/exfoliation est réduit jusqu'à être même inhibé. Les inventeurs ont par exemple pu observer par SEM, d'une part, une exfoliation de surface et la présence de microfissures au niveau du plan de fragilisation après une irradiation à 2,15 J/cm² (ce qui est compatible avec une initiation de la fracture) et, d'autre part, la présence de microbulles au niveau du plan de fragilisation après une irradiation à 2,75 J/cm² (ce qui comme montré sur la figure 2 n'engendre pas de cloquage/exfoliation et n'est donc pas compatible avec une initiation de la fracture).

On déduit de ce qui précède que dans le cadre d'une irradiation par une seule impulsion, il est préférable de ne pas avoir recours à des fluences comprises entre 1,6 et 1,9 J/cm² ou à des fluences supérieures à 3 J/cm² pour éviter une dégradation de surface mais de privilégier plutôt des fluences comprises entre 1,9 et 3 J/cm². Dans cette dernière gamme, plus la fluence est élevée, plus le phénomène de cloquage est inhibé et donc plus la capacité d'initiation de l'onde de fracture est réduite.

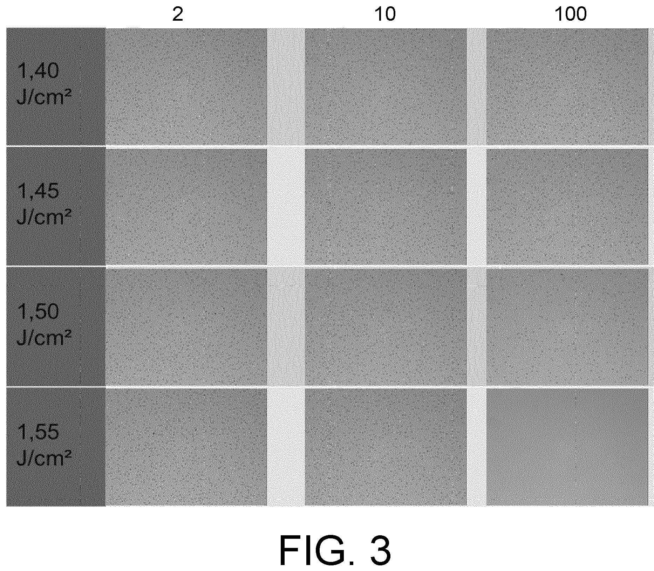

On a représenté sur la figure 3 des observations microscopiques de régions irradiées par 2, 10 ou 100 impulsions NSLA après qu'elles aient été soumises au traitement thermique de vérification du cloquage. On constate que l'augmentation du nombre d'impulsions permet d'augmenter l'effet d'inhibition. En particulier, pour l'exemple de 100 impulsions, l'effet d'inhibition est prononcé dès une fluence de 1,55 J/cm².

Il ressort de ce qui précède qu'il est possible de réduire voire d'inhiber le cloquage en utilisant un recuit laser et qu'il est possible d'adapter la fluence et le nombre d'impulsions pour atteindre l'effet d'inhibition recherché. Revenant à la description du procédé selon l'invention, celui-ci peut donc peut comprendre une irradiation localisée de la face libre de la couche mince (i.e. sa face destinées à être mise en contact avec le substrat receveur) par une ou plusieurs impulsions laser. Il est bien sûr possible d'irradier plusieurs zones cible, et même d'appliquer des paramètres d'irradiation différents (fluence et nombre d'impulsions notamment) entre les zones cibles.

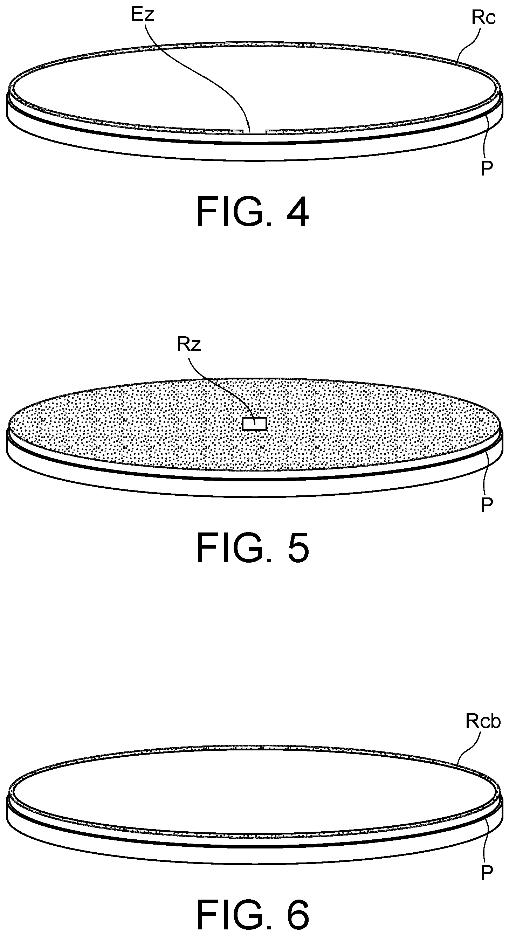

Dans un exemple de réalisation possible, lors de l'étape de réduction localisée de la capacité à initier l'onde de fracture, une couronne périphérique du plan de fragilisation P, à l'exception d'un secteur de la couronne périphérique, est soumise à ladite réduction. L'épaisseur de la couronne périphérique est par exemple de 100 µm à 10 mm, typiquement 500 µm à 2 mm. Le secteur occupe une surface comprise entre 200x200 µm² et 20x20 mm² (ce qui correspond à une ouverture angulaire comprise entre quelques dizièmes de degrés environ et 10 degrés). Pour ce faire, et comme illustré par la figure 4, un recuit laser peut être appliqué sur une région cible périphérique Rc de la surface du substrat donneur correspondant à ladite couronne périphérique à l'exception d'une portion Ez de cette région cible correspondant audit secteur. Dans le cadre de cet exemple de réalisation, l'initiation de l'onde de fracture peut comprendre un apport d'énergie localisé (par exemple un chauffage localisé) au niveau du secteur de la couronne périphérique non soumis à la réduction localisée à initier l'onde de fracture.

Dans un autre exemple de réalisation, lors de l'étape de réduction localisée de la capacité à initier l'onde de fracture, l'intégralité du plan de fragilisation P est soumise à ladite réduction à l'exception d'une zone (par exemple une zone centrale qui peut occuper une surface comprise entre 100X100 µm² et 30X30 mm²) du plan de fragilisation. Pour ce faire, et comme illustré par la figure 5, un recuit laser peut être appliqué sur l'intégralité de la surface du substrat donneur à l'exception d'une région Rz correspondant à ladite zone. Dans le cadre de cet exemple, la réduction localisée de la capacité à initier l'onde de fracture est de préférence réalisée de manière à ne pas faire obstacle à la propagation de l'onde de fracture. Pour cela, le recuit laser peut être effectué à une fluence qui n'inhibe pas complément la formation de microfissures et ne vient pas former exclusivement des microbulles comme on a pu le voir dans l'exemple exposé précédemment.

Dans un autre exemple de réalisation possible, lors de l'étape de réduction localisée de la capacité à initier l'onde de fracture, une couronne périphérique du plan de fragilisation P présente en bordure du substrat donneur est soumise à ladite réduction de la capacité d'initiation de l'onde de fracture. Pour ce faire, et comme illustré par la figure 8, un recuit laser peut être appliqué sur la surface du substrat donneur sur une région cible périphérique Rcb correspondant à ladite couronne périphérique.

La région cible périphérique Rcb recouvre de préférence la couronne en bord de plaque qui du fait d'un chanfrein n'est pas collée au substrat receveur et n'y est pas transférée. En effet, en l'absence de mise en œuvre de l'invention, cette couronne non-collée est le siège de phénomènes de cloquage/exfoliation lors du traitement thermique de fragilisation. Des défauts sont alors générés dont il convient de se débarrasser par un post-traitement spécifique. Avec la mise en œuvre de l'invention, il est possible de réduire voire d'éliminer ces phénomènes de cloquage/exfoliation au niveau de la couronne non-collée et par conséquent de ne pas avoir à réaliser un post-traitement spécifique de défauts qui seraient générés par ces phénomènes.

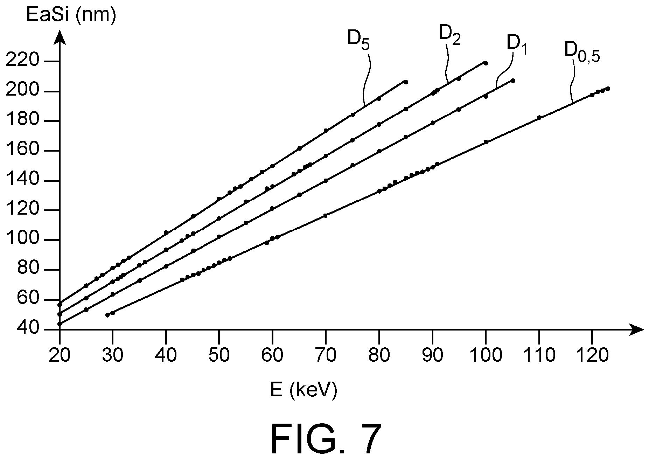

Dans un autre mode de réalisation possible de l'invention, la réduction localisée de la capacité du plan de fragilisation à initier l'onde de fracture peut comprendre, avant ou après la formation du plan de fragilisation, la formation d'une zone amorphe localisée dans la couche mince au droit de la zone où la capacité à initier l'onde de fracture doit être réduite. En localisant une zone amorphe au voisinage du plan de fragilisation, par exemple à moins de 100 nm et avantageusement à moins de 75 nm ou 50 nm du plan de fragilisation, on peut en effet limiter voire inhiber le bullage au niveau de la zone du plan de fragilisation située à l'aplomb de cette zone amorphe. La zone amorphe est de préférence formée après la formation du plan de fragilisation pour ne pas interférer avec cette formation. La zone amorphe peut être obtenue par implantation ionique à base notamment d'une ou plusieurs des espèces suivantes : silicium, germanium, phosphore, arsenic, azote ou argon avec une dose typiquement comprise entre 10¹⁴ et 10¹⁶ at/cm². La figure 7 représente l'épaisseur d'une zone de silicium EaSi rendue amorphe au moyen d'une implantation de silicium en fonction de l'énergie d'implantation E pour différentes doses d'implantation (D_{0,5} : 5.10¹⁴ at/cm² ; D₁ : 10¹⁵ at/cm² ; D₂ : 2.10¹⁵ at/cm² ; D₅ : 5.10¹⁵ at/cm²).

## Revendications

1. Procédé de transfert d'une couche mince d'un substrat donneur vers un substrat receveur, le procédé comprenant les étapes suivantes :
- implantation d'espèces réalisée de manière uniforme sur l'ensemble du substrat donneur pour y former un plan de fragilisation (P) qui délimite la couche mince et une partie massive du substrat donneur,
- mise en contact du substrat donneur et du substrat receveur,
- initiation et propagation de l'onde de fracture le long du plan de fragilisation,
le procédé étant **caractérisé en ce qu'**il comporte avant la mise en contact une étape de réduction localisée d'une capacité du plan de fragilisation à initier l'onde de fracture.

2. Procédé selon la revendication 1, dans lequel, lors de l'étape de réduction localisée de la capacité du plan de fragilisation à initier l'onde de fracture, une zone centrale (Rz) du plan de fragilisation n'est pas soumise à la réduction de la capacité à initier l'onde de fracture.

3. Procédé selon l'une des revendications 1 et 2, dans lequel, lors de l'étape de réduction localisée de la capacité du plan de fragilisation à initier l'onde de fracture, une couronne périphérique (Rcb) du plan de fragilisation est soumise à la réduction de la capacité à initier l'onde de fracture.

4. Procédé selon l'une des revendications 1 et 2, dans lequel, lors de l'étape de réduction localisée de la capacité du plan de fragilisation à initier l'onde de fracture, une couronne périphérique (Rc) du plan de fragilisation, à l'exception d'un secteur (Ez) de la couronne périphérique, est soumise à la réduction de la capacité à initier l'onde de fracture.

5. Procédé selon la revendication 4, dans lequel l'initiation de l'onde de fracture comprend un apport d'énergie localisé au niveau du secteur de la couronne périphérique non soumis à la réduction de la capacité à initier l'onde de fracture.

6. Procédé selon l'une des revendications 3 à 5, dans lequel la couronne périphérique est localisée en bordure du plan de fragilisation.

7. Procédé selon l'une des revendications 1 à 6, dans lequel l'étape de réduction localisée de la capacité du plan de fragilisation à initier l'onde de fracture comprend la réalisation d'un recuit laser localisé du substrat donneur.

8. Procédé selon la revendication 7, dans lequel la réalisation du recuit laser localisé du substrat donneur comprend une irradiation localisée d'une face libre de la couche mince par une ou plusieurs impulsions laser.

9. Procédé selon l'une des revendications 1 à 6, dans lequel l'étape de réduction localisée de la capacité du plan de fragilisation à initier l'onde de fracture comprend la formation d'une zone amorphe localisée dans la couche mince.

10. Procédé selon la revendication 9, dans lequel la zone amorphe est localisée à moins de 100 nm, de préférence à moins de 75 nm, et encore plus de préférence à moins de 50 nm du plan de fragilisation.

## Patentansprüche

1. Verfahren zum Transferieren einer Dünnschicht von einem Spendersubstrat auf ein Empfängersubstrat, wobei das Verfahren die folgenden Schritte umfasst:
- gleichmäßiges Implantieren von Arten auf dem gesamten Spendersubstrat, um dort eine Versprödungsebene (P) zu bilden, die die Dünnschicht und einen massiven Teil des Spendersubstrats abgrenzt,
- Kontaktieren des Spendersubstrats und des Empfängersubstrats,
- Einleiten und Ausbreiten der Bruchwelle entlang der Versprödungsebene, wobei das Verfahren **dadurch gekennzeichnet ist, dass** es vor dem Kontaktieren einen Schritt zum lokalisierten Reduzieren einer Fähigkeit der Versprödungsebene, die Bruchwelle einzuleiten, umfasst.

2. Verfahren nach Anspruch 1, wobei beim Schritt des lokalisierten Reduzierens der Fähigkeit der Versprödungsebene, die Bruchwelle einzuleiten, ein zentraler Bereich (Rz) der Versprödungsebene nicht dem Reduzieren der Fähigkeit, die Bruchwelle einzuleiten, unterliegt.

3. Verfahren nach einem der Ansprüche 1 und 2, wobei beim Schritt des lokalisierten Reduzierens der Fähigkeit der Versprödungsebene, die Bruchwelle einzuleiten, eine periphere Krone (Rcb) der Versprödungsebene dem Reduzieren der Fähigkeit, die Bruchwelle einzuleiten, unterliegt.

4. Verfahren nach einem der Ansprüche 1 und 2, wobei beim Schritt des lokalisierten Reduzierens der Fähigkeit der Versprödungsebene, die Bruchwelle einzuleiten, eine periphere Krone (Rc) der Versprödungsebene, mit Ausnahme eines Sektors (Ez) der peripheren Krone, dem Reduzieren der Fähigkeit, die Bruchwelle einzuleiten, unterliegt.

5. Verfahren nach Anspruch 4, wobei das Einleiten der Bruchwelle eine lokalisierte Energiezufuhr am Sektor der peripheren Krone umfasst, die nicht dem Reduzieren der Fähigkeit, die Bruchwelle einzuleiten, unterliegt.

6. Verfahren nach einem der Ansprüche 3 bis 5, wobei die periphere Krone am Rand der Versprödungsebene lokalisiert ist.

7. Verfahren nach einem der Ansprüche 1 bis 6, wobei der Schritt des lokalisierten Reduzierens der Fähigkeit der Versprödungsebene, die Bruchwelle einzuleiten, das Durchführen eines lokalisierten Laserglühens des Spendersubstrats umfasst.

8. Verfahren nach Anspruch 7, wobei das Durchführen des lokalisierten Laserglühens des Spendersubstrats ein lokalisiertes Bestrahlen einer freien Seite der Dünnschicht durch einen oder mehrere Laserimpulse umfasst.

9. Verfahren nach einem der Ansprüche 1 bis 6, wobei der Schritt des lokalisierten Reduzierens der Fähigkeit der Versprödungsebene, die Bruchwelle einzuleiten, das Bilden eines lokalisierten amorphen Bereichs in der Dünnschicht umfasst.

10. Verfahren nach Anspruch 9, wobei der amorphe Bereich weniger als 100 nm, vorzugsweise weniger als 75 nm und noch bevorzugter weniger als 50 nm von der Versprödungsebene entfernt ist.

## Claims

1. A method for transferring a thin layer from a donor substrate to a receiver substrate, the method including the steps of:
- implanting species in a uniform manner on the whole of the donor substrate to form therein an embrittlement plane (P) which delimits the thin layer and a bulk part of the donor substrate,
- placing in contact the donor substrate and the receiver substrate,
- initiating and propagating a fracture wave along the embrittlement plane,
the method being **characterised in that** it comprises, before the placing in contact, a step of locally reducing a capacity of the embrittlement plane to initiate the fracture wave.

2. The method according to claim 1, in which, during the step of locally reducing the capacity of the embrittlement plane to initiate the fracture wave, a central zone (Rz) of the embrittlement plane is not subjected to the reduction of the capacity to initiate the fracture wave.

3. The method according to one of claims 1 and 2, in which, during the step of locally reducing the capacity of the embrittlement plane to initiate the fracture wave, a peripheral crown (Rcb) of the embrittlement plane is subjected to the reduction of the capacity to initiate the fracture wave.

4. The method according to one of claims 1 and 2, in which, during the step of locally reducing the capacity of the embrittlement plane to initiate the fracture wave, a peripheral crown (Rc) of the embrittlement plane, with the exception of a sector (Ez) of the peripheral crown, is subjected to the reduction of the capacity to initiate the fracture wave.

5. The method according to claim 4, in which initiating the fracture wave includes locally inputting energy at the level of the sector of the peripheral crown not subjected to the reduction of the capacity to initiate the fracture wave.

6. The method according to one of claims 3 to 5, in which the peripheral crown is localised at the edge of the embrittlement plane.

7. The method according to one of claims 1 to 6, in which the step of locally reducing the capacity of the embrittlement plane to initiate the fracture wave includes carrying out a localised laser annealing of the donor substrate.

8. The method according to claim 7, in which carrying out the localised laser annealing of the donor substrate includes locally irradiating a free face of the thin layer by one or more laser pulses.

9. The method according to one of claims 1 to 6, in which the step of locally reducing the capacity of the embrittlement plane to initiate the fracture wave includes forming a localised amorphous zone in the thin layer.

10. The method according to claim 9, in which the amorphous zone is localised at less than 100 nm, preferably at less than 75 nm, and even more preferably at less than 50 nm from the embrittlement plane.
